# EUROPÄISCHE PATENTANMELDUNG

(11) **EP 0 874 392 A1**
(43) Veröffentlichungstag der Anmeldung: **28.10.1998**
(21) Anmeldenummer: 98106633.5
(22) Anmeldetag: 09.04.1998
(51) Int. Cl.: H01L 21/3205, H01L 21/8239

(54) **Verfahren zum Herstellen einer Kapazitätsstruktur auf einem Siliziumsubstrat in einem MOS-Prozess**

(30) Priorität: 26.04.1997 DE 19717792
(71) Anmelder: Micronas Intermetall GmbH, 79108 Freiburg (DE)
(72) Erfinder: Frerichs, Heinz-Peter, Dr. Dipl.-Phys., 79271 St. Peter (DE)
(74) Vertreter: Hornig, Leonore, Dr.

(57) **Zusammenfassung**

Die Erfindung betrifft ein Verfahren zum Herstellen einer Kapazitätsstruktur auf einem Siliziumsubstrat in einem MOS-Prozeß, das dadurch vereinfacht wird, daß auf eine erste Polysiliziumschicht 7 eine Isolatorschicht 8 und auf diese eine zweite Polysiliziumschicht 9 zur Erzeugung einer Kapazitätsstruktur 10 aufgebracht wird, die zweite Polysiliziumschicht 9 und die Isolatorschicht 8 derart strukturiert werden, daß eine erste Kondensatorplatte 11 und ein Dielektrikum 12 der Kapazitätsstruktur 18 erzeugt werden, danach die erste Polysiliziumschicht 7 und die Gateoxidschicht 6 derart strukturiert werden, daß eine zweite Kondensatorplatte 14 der Kapazitätsstruktur 18 und die Gatebereiche von MOS-Transistoren ausgebildet werden und danach die MOS-Transistoren erzeugt werden.

## Beschreibung

Die Erfindung betrifft ein Verfahren zum Herstellen einer Kapazitätsstruktur auf einem Siliziumsubstrat in einem MOS-Prozeß, bei den` auf der Oberfläche des Substrats Feldoxidbereiche zur Isolation ausgebildet werden und eine Gateoxidschicht und eine erste Polysiliziumschicht zur Erzeugung von Gate-Bereichen aufgebracht werden.

Ein solches Verfahren ist aus der Praxis bekannt. Es dient zur Herstellung von integrierten Schaltungen, die in einem Standard MOS-Prozeß hergestellt werden. Dabei können mehrere verschiedene Funktionsblöcke einer integrierten Schaltung auf einem Substrat in dem Standard MOS-Prozeß erzeugt werden. Es werden dabei durch verschiedene lithographische Schritte in Verbindung mit Abscheiden von Schichten, Oxidieren verschiedener Bereiche und Implantationsverfahren Transistoren hergestellt und in geeigneter Weise elektrisch miteinander verbunden. In derartigen Schaltungen sind auch zusätzliche definierte Kapazitäten erforderlich, welche durch zwei aufeinanderliegende Polysiliziumschichten mit einer dazwischenliegenden, als Dielektrikum dienenden Isolatorschicht realisiert werden können. Zur Herstellung der Kapazitätsstruktur werden die erste Polysitiziumschicht und die Gateoxidschicht so geätzt, daß Gate-Bereiche und eine erste Kondensatorplatte der Kapazitätsstruktur entstehen. Dann wird eine Isolatorschicht zur Erzeugung des Dielektrikums aufgebracht. Durch lithographische Schritte wird diese in den Gate-Bereichen wieder weggeätzt. Danach wird eine zweite Polysiliziumschicht aufgebracht und derart strukturiert, daß die Gates der Transistoren und die zweite Kondensatorplatte der Kapazitätsstruktur erzeugt werden. Dieses Verfahren ist zum einen aufwendig, da zusätzliche Verfahrensschritte, wie Dotieren der einzelnen Polysiliziumschichten für die Kapazitätsstruktur, damit verbundene weitere Maskenschritte, zusätzliche thermische Behandlungen und Ätzprozesse erforderlich sind. Hierdurch werden die elektrischen Eigenschaften der MOS-Transistoren beeinflußt. Es ist insbesondere störend, daß ein weiterer Ätzprozeß auf dem Transistorgebiet des Siliziumsubstrats durchgeführt wird.

Der Erfindung liegt die Aufgabe zugrunde, ein einfacheres und besseres Verfahren zum Herstellen einer Kapazitätsstruktur auf einem Siliziumsubstrat in einem MOS-Prozeß zu schaffen.

Diese Aufgabe wird durch ein gattungsgemäßes Verfahren gelöst, bei dem auf die erste Polysiliziumschicht eine Isolatorschicht und auf diese eine zweite Polysiliziumschicht zur Erzeugung einer Kapazitätsstruktur aufgebracht wird, die zweite Polysiliziumschicht und die Isolatorschicht derart strukturiert werden, daß eine erste Kondensatorplatte und ein Dielektrikum der Kapazitätsstruktur erzeugt werden, danach die erste Polysiliziumschicht und die Gateoxidschicht derart strukturiert werden, daß eine zweite Kondensatorplatte der Kapazitätsstruktur und die Gate-Bereiche von MOS-Transistoren ausgebildet werden und danach die MOS-Transistoren erzeugt werden.

Bei dem erfindungsgemäßen Verfahren ist zum Erzeugen der Kapazitätsstruktur nur ein zusätzlicher Maskenschritt erforderlich, da die erste Polysiliziumschicht erst dann strukturiert wird, nachdem die zweite Polysiliziumschicht aufgebracht worden ist. Danach können die beiden Polysiliziumschichten gleichzeitig weiterbehandelt werden. Außerdem wird bei dem erfindungsgemäßen Verfahren vermieden, daß in den für die MOS-Transistoren vorgesehenen Gebieten Ätzprozesse durchgeführt werden. Da die zweite Polysiliziumschicht lediglich von der ersten Polysiliziumschicht entfernt wird, gelangt die Ätzsubstanz nicht auf die Oberfläche des Siliziumsubstrats bzw. auf die darauf aufgebrachte Gateoxidschicht. Es werden daher auch die Source- und Drainbereiche für die Transistoren beim Ausbilden der Kapazitätsstruktur nicht beeinfluß. Es werden somit die elektrischen Parameter der Transistoren nicht verändert. Die MOS-Transistoren werden mit den Standard MOS-Verfahrensschritten vollständig hergestellt. Es werden insbesondere die Source- und Drainbereiche durch entsprechende Dotierung erzeugt, und die Kontaktierung der Transistoren und der Kapazitätsstrukturen sowie die elektrischen Verbindungen hergestellt.

Nach einer erfindungsgemäßen Weiterbildung des Verfahrens wird in die erste und in die zweite Polysiliziumschicht jeweils ein Implantierstoff zur Dotierung eingebracht. Die Aktivierung der Dotierung in der ersten und in der zweiten Polysiliziumschicht kann gleichzeitig durch eine Temperbehandlung erfolgen. Es ist somit nur ein Temperschritt zum Aktivieren der Dotierung für die Kapazitätsstruktur und weiteren Polysiliziumstrukturen, die aus der ersten Polysiliziumschicht gebildet sind, wie Widerstandsstrukturen oder Gatestrukturen, erforderlich.

Vorteilhafterweise wird die Isolatorschicht aus Silizium-Oxinitrid gebildet. Dieses Material hat den Vorteil, daß es bei einer Temperatur aufgebracht werden kann, bei der sich die Eigenschaften der MOS-Transistoren nicht verändern. Zusätzlich hat es gute Isolatoreigenschaften und eine hohe Dielektrizitätskonstante. Es kann auch einfach aufgebracht werden. Es ist auch möglich eine andere Isolatorschicht wie Siliziumoxid oder eine Schicht aus Siliziumoxid, Siliziumnitrid und Siliziumoxid aufzubringen, falls andere Anforderungen an die Kapazitätsstruktur gestellt werden.

Im folgenden wird die Erfindung anhand der Zeichnung näher erläutert.

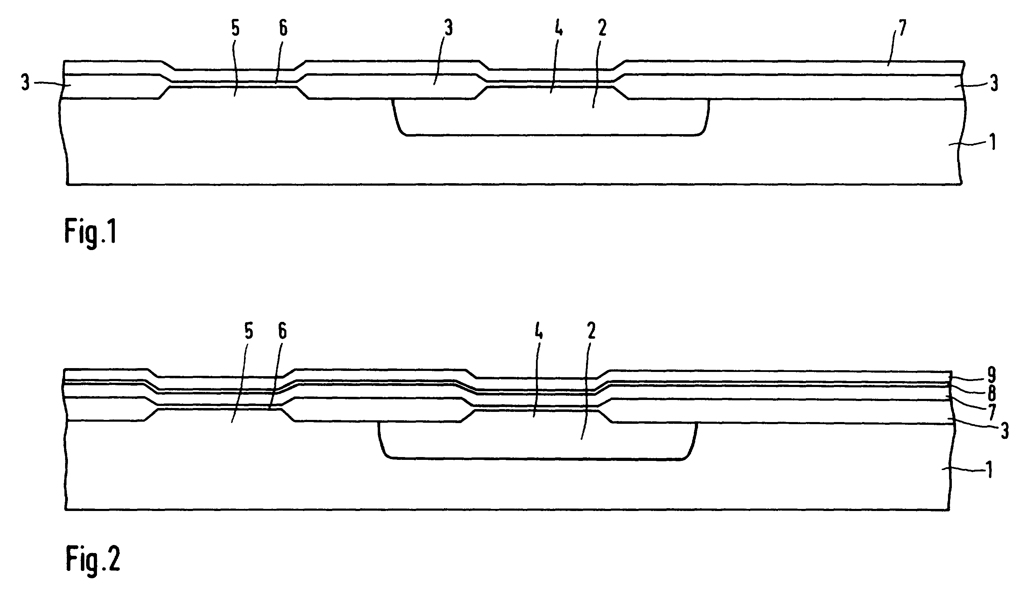

Fig. 1 bis 5 zeigen eine nach dem erfindungsgemäßen Verfahren hergestellte Kapazitätsstruktur auf einem Siliziumsubstrat in einer MOS-Anordnung nach verschiedenen Verfahrensschritten.

In Fig. 1 ist ein Siliziumsubstrat 1 eines ersten Leitungstyps gezeigt, in dem eine Wanne 2 eines zweiten Leitungstyps ausgebildet ist. Auf der Oberfläche des Siliziumsubstrats 1 sind Feldoxidbereiche 3 ausgebildet, die zur Isolation dienen. Durch sie werden elektrisch voneinander getrennte Bereiche zum Ausbilden von verschiedenen MOS-Transistoren voneinander isoliert. Wenn das Siliziumsubstrat 1 p-leitend ist, ist der Wannenbereich 2 n-leitend, so daß dort ein PMOS-Transistor ausgebildet werden kann. Der durch eine Öffnung in dem Feldoxidbereich 3 definierte Bereich 5 ist zur Ausbildung eines NMOS-Transistors vorgesehen. Auf der Oberfläche des Siliziumsubstrats 1 mit den Feldoxidbereichen 3 ist eine Gateoxidschicht 6 aufgebracht, auf welche eine erste Polysiliziumschicht 7 aufgebracht ist. Die Polysiliziumschicht 7 kann durch eine in der Technologie übliche Implantation mit z.B. Phosphorionen implantiert werden. Die Gateoxidschicht 6 und erste Polysiliziumschicht 7 dienen dazu, in den Bereichen 4 und 5 Gatebereiche zu erzeugen.

Wie in Fig. 2 gezeigt ist, wird auf die erste Polysiliziumschicht 7 eine Isolatorschicht 8 und auf diese eine zweite Polysiliziumschicht 9 aufgebracht. Die Isolatorschicht 8 kann aus einem Oxid, einer bestimmten Schichtenfolge beispielsweise eine Oxid, Nitrid oder aus einem Oxinitrid gebildet werden. Die erste Polysiliziumschicht 7, die Isolatorschicht 8 und die zweite Polysiliziumschicht 9 dienen dazu, eine Kapazitätsstruktur 18 auszubilden. Die zweite Polysiliziumschicht 9 kann durch eine in der MOS-Technologie übliche Implantation mit Ionen, insbesondere Phosphor, aktiviert werden. Danach wird eine Temperbehandlung zur Aktivierung der Dotierung in der ersten und der zweiten Polysiliziumschicht 7,8 durchgeführt, wodurch die Dotierstoffe auf ihre Gitterplätze gelangen.

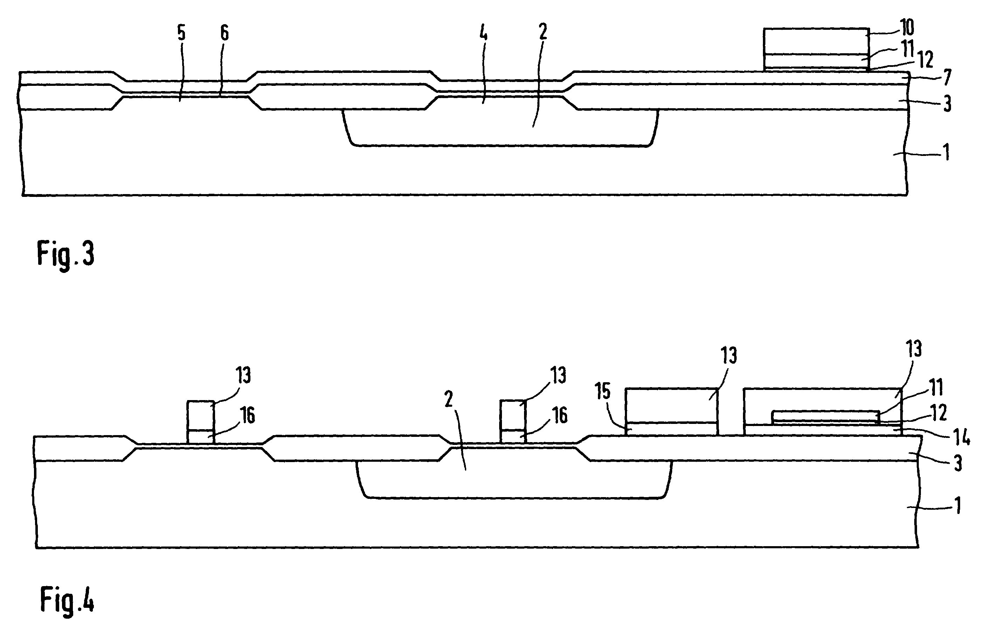

In Fig. 3 ist zu sehen, wie die zweite Polysiliziumschicht 9 und die Isolatorschicht 8 mittels einer Maskierschicht 10 derart strukturiert sind, daß aus der zweiten Polysiliziumschicht 9 eine erste Kondensatorplatte 11 und ein Dielektrikum 12 der Kapazitätsstruktur 18 entsteht. Dies ist der einzige Maskenschritt, der zusätzlich zu dem MOS-Prozeß, hier zum Ausbilden des PMOS- und des NMOS-Transistors, erforderlich ist, um die Kapazitätsstruktur zu erzeugen. Die dazu erforderlichen Verfahrensschritte, wie Maskieren, Ätzen und Dotieren der zweiten Polysiliziumschicht 9 erfolgen dabei, bevor die MOS Transistoren hergestellt werden, so daß deren elektrische Eigenschaften durch diese Verfahrensschritte nicht beeinflußt werden. Zudem erfolgen zusätzliche Ätzschritte, insbesondere das Wegätzen der Isolatorschicht 8 und der ersten Polysiliziumschicht 7 in den Bereichen 4 und 5 auf der ersten Polysiliziumschicht 7 und nicht direkt auf dem Siliziumsubstrat 1. Dadurch werden die Bereiche 4 und 5 auch nicht durch das Ätzen beeinflußt.

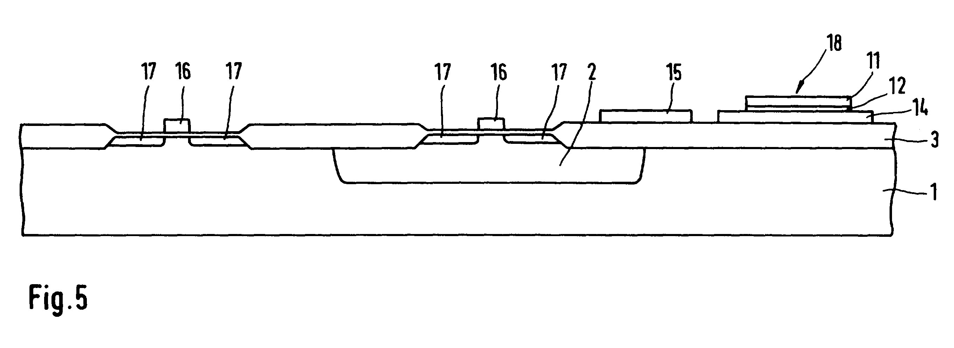

Danach wird entsprechend der Darstellung in Fig. 4 die erste Polysiliziumschicht 7 mit einer weiteren Maskierschicht 13 strukturiert. Dabei werden die zweite Kondensatorplatte 14 der Kapazitätsstruktur, eine Widerstandsstruktur 15 sowie Gatebereiche 16 für die herzustellenden MOS-Transistoren ausgebildet. Danach werden die Source- und Drainbereiche 17 der MOS-Transistoren durch Standard MOS-Verfahrensschritte, wie Dotieren und Tempern erzeugt. Die Maskierschicht 13 wird nach dem Herstellen der Source- und Drainbereiche entfernt. In diesem Zustand ist die MOS-Struktur in Fig. 5 gezeigt. Es werden danach noch die MOS-Transistoren, die Widerstandsstruktur 15 und die Kapazitätsstruktur 18 kontaktiert und elektrische Verbindungsleitungen aufgebracht.

## Patentansprüche

1. Verfahren zum Herstellen einer Kapazitätsstruktur auf einem Silizium-Substrat in einem MOS-Prozeß,
bei dem auf der Oberfläche des Substrats (1) Feldoxidbereiche (3) zur Isolation ausgebildet werden und
eine Gateoxidschicht (6) und eine erste Polysiliziumschicht (7) zur Erzeugung von Gatebereichen (16) aufgebracht werden,
dadurch gekennzeichnet,
daß auf die erste Polysiliziumschicht (7) eine Isolatorschicht (8) und auf diese eine zweite Polysiliziumschicht (9) zur Erzeugung einer Kapazitätsstruktur (18) aufgebracht wird,
daß die zweite Polysiliziumschicht (9) und die Isolatorschicht (8) derart strukturiert werden, daß eine erste Kondensatorplatte (11) und ein Dielektrikum (12) der Kapazitätsstruktur (18) erzeugt werden,
daß danach die erste Polysiliziumschicht (7) und die Gateoxidschicht (6) derart strukturiert werden, daß eine zweite Kondensatorplatte (14) der Kapazitätsstruktur (18) und die Gatebereiche (16) von MOS-Transistoren ausgebildet werden
und daß danach die MOS-Transistoren erzeugt werden.

2. Verfahren nach Anspruch 1, dadurch gekennzeichnet, daß in die erste und in die zweite Polysiliziumschicht (7, 9) ein Implantierstoff zur Dotierung eingebracht wird, und nur eine Temperbehandlung zur Aktivierung der Dotierung in der ersten und in der zweiten Polysiliziumschicht (7,9) durchgeführt wird.

3. Verfahren nach einem der vorangehenden Patentansprüche, dadurch gekennzeichnet, daß die Isolatorschicht (8) aus Silizium-Oxinitrid gebildet wird.
